(19) Europäisches Patentamt
European Patent Office
Office européen des brevets

(11) **EP 2 202 527 A1**

(12) **EUROPEAN PATENT APPLICATION**

(43) Date of publication:
**30.06.2010  Bulletin 2010/26**

(51) Int Cl.:
***G01R 15/20*** *(2006.01)*

(21) Application number: **08172671.3**

(22) Date of filing: **23.12.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **ABB Research Ltd.**
**8050 Zürich (CH)**

(72) Inventors:
• **Deck, Bernhard**
  **79809 Weilheim (DE)**

• **Andenna, Andrea**
  **5405 Baden-Dättwil (CH)**
• **Bloch, Richard**
  **5415 Nussbaumen (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(54) **Current measurement device and method**

(57)    A current measurement device is prcvided which is adapted for measuring an electrical current (203) flowing through an electrical conductor (201). The current measurement device includes two magnetic field sensors (102,103) adapted for sensing a magnetic field (202) generated by the electrical current to be measured, and a one-piece support unit (106) having a fastening section for fastening the electrical conductor. The one-piece support unit is adapted to hold the two magnetic field sensors adjacent to the electrical conductor when the electrical ccnductor is fastened tc the fastening section. The magnetic field sensors are arranged on the one-piece support unit such that when the electrical conductor is fastened to the fastening section, a magnetic field generated by the electrical current to be measured penetrates the two magnetic field sensors in mutually opposite directions.

**100**

**Fig. 3**

EP 2 202 527 A1

**Description**

**BACKGROUND**

The present disclosure generally relates to current measurement devices, and in particular relates to a current measurement device adapted for measuring electrical currents flowing through an electrical conductor.

The measurement of currents flowing through an electrical conductor is an important issue in electronic circuit analysis. A current flowing through an inductor causes a magnetic field around the conductor according to the magnetic flux law.

Thus it is possible to measure the current flowing through an inductor without interrupting the inductor, i.e. the current is measured indirectly via the magnetic field caused by the current. Such kind of measurement devices are based on the measurement of magnetic fields such that sensitive magnetic field sensors are employed in order to measure currents in a wide dynamic range.

Since especially in low current applications the magnetic field generated by the current flowing through the conductor is very low, parasitic magnetic fields may interfere with the magnetic field to be measured. When parasitic magnetic fields are present, disadvantageously the signal-to-noise-ratio of a current measurement using magnetic field sensors may be low.

**SUMMARY**

In view of the above, it is an object of the present invention to provide a current measurement device and a current measurement method with improved performance.

According to an aspect a current measurement device adapted for measuring an electrical current flowing through an electrical conductor is provided, the current measurement device including two magnetic field sensors adapted for sensing a magnetic field generated by the electrical current to be measured, and a one-piece support unit having a fastening section for fastening the electrical conductor, the one-piece support unit being adapted to hold the two magnetic field sensors adjacent to the electrical conductor when the electrical conductor is fastened to the fastening section, wherein the magnetic field sensors are arranged on the one-piece support unit such that when the electrical conductor is fastened to the fastening section, a magnetic field generated by the electrical current to be measured penetrates the two magnetic field sensors in mutually opposite directions.

According to another aspect a method for measuring an electrical current flowing through an electrical conductor is provided, the method including the steps of providing two magnetic field sensors, fastening the electrical conductor to a one-piece support unit by means of a fastening section of the one-piece support unit, thereby holding the two magnetic field sensors adjacent to the electrical conductor such that a magnetic field generated by the electrical current to be measured penetrates the two magnetic field sensors in mutually opposite directions, and sensing the magnetic field generated by the electrical current to be measured.

Further exemplary embodiments are according to the dependent claims, the description and the accompanying drawings.

**DRAWINGS**

A full and enabling disclosure, including the best mode thereof, to one of ordinary skill in the art is set forth more particularly in the remainder of the specification including reference to the accompanying drawings wherein:

Fig. 1 illustrates a principle of a current measurement method by means of detecting a magnetic field generated by a current flowing through a current conductor;

Fig. 2 is a schematic perspective view of a magnetic field sensor unit based on the Hall effect;

Fig. 3 is a schematical sectional view of a current measurement device having two magnetic field sensor units arranged in the vicinity of a current detector, according to a typical embodiment;

Fig. 4 is the current measurement device as shown in Fig. 3 in a side view;

Fig. 5 is a current measurement device having first and second magnetic field sensor groups adapted for measuring an electric current flowing through a current conductor, the electric current generating a magnetic field, according to another typical embodiment;

Fig. 6 illustrates a current measurement device adapted for measuring an electric current through a current conductor wherein magnetic field sensor units are arranged in a comb-like structure, according to yet another typical embodiment;

Fig. 7 is a top view of the current measurement device shown in Fig. 6 illustrating an arrangement of a current conductor within the comb-like structure of the current measurement device; and

Fig. 8 is a schematic flowchart illustrating a method for measuring an electrical current flowing through an electrical conductor according to a typical embodiment.

**DETAILED DESCRIPTION**

Reference will now be made in detail to the various exemplary embodiments, one or more examples of which are illustrated in the drawings. Each example is provided by way of explanation and is not meant as a limitation. For example, features illustrated or described as part of one embodiment can be used on or in conjunction with other embodiments to yield yet a further embodiment. It is intended that the present disclosure includes such modifications and variations.

A number of embodiments will be explained below. In this case, identical structural features are identified by identical reference symbols in the drawings. The structures shown in the drawings are not depicted true to scale but rather serve only for the better understanding of the embodiments.

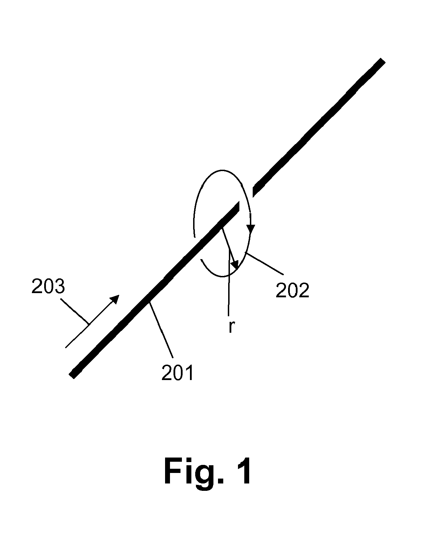

Fig. 1 illustrates the generation of a magnetic field 202 to be measured by means of a current 203 which flows through a current conductor 201.

In the schematic set-up shown in Fig. 1, the electrical conductor 201 is provided as a thin wire wherein the current flows in the direction indicated by reference numeral 203. The current 203 flowing through the electrical conductor 201 generates a rotationally symmetric magnetic field 202 about the electrical conductor 201.

The direction of the magnetic field 201 is indicated by the arrow of a reference numeral 202, wherein the strength (absolute value) of the magnetic field 202 depends on a distance r off the center of the electrical conductor 201. In accordance with the magnetic flux law, the value of the magnetic field depends on the current 203 (I) flowing through the electrical conductor 201 according to the following equation:

$$H(r) \;=\; \frac{I}{2\pi r} \qquad\qquad (1)$$

The magnetic induction B may be derived by using the magnetic field constant $\mu_0$ multiplied by the magnetic field H in A/m in accordance with the following equation (2):

$$B \;=\; \mu_0 \, H \qquad\qquad (2)$$

The magnetic field constant amounts to:

$$\mu_0 \;=\; 4\pi \;\cdot\; 10^{-7}\;\frac{Vs}{Am} \qquad\qquad (3)$$

such that the magnetic induction is given in units of $Vs/m^2$.

As indicated in the principal set-up shown in Fig. 1, it is possible to detect an electrical current 203 flowing through an electrical conductor 201 by probing the magnetic field 202 generated by the electric current 203 to be measured at a specific distance r from the electrical conductor 201. Thus, the electric current 203 flowing in an electrical conductor 201 can be unambiguously measured without interrupting the current path and/or inserting a current measurement device in the current path of the electrical conductor 201.

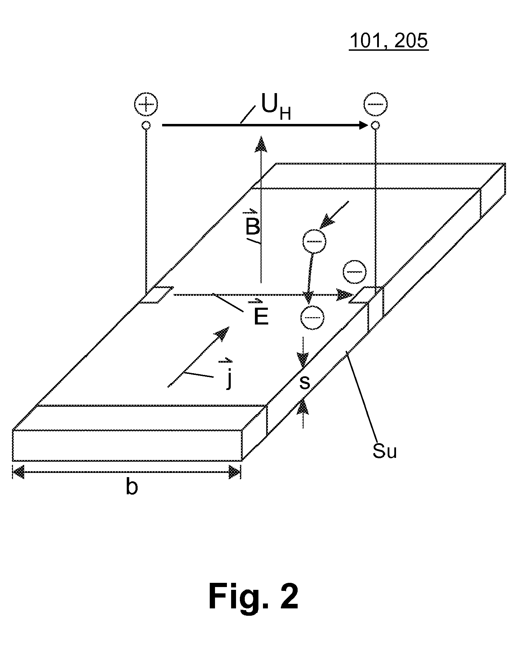

Fig. 2 is a perspective view of a magnetic field sensor unit 101 based on the Hall effect principle. A magnetic induction B in accordance with equation (2) above penetrates a flat (thickness s) semiconductor substrate Su. At opposite lateral sides of the semiconductor substrate, electrodes are provided, i.e. a pair of electrodes "+" and "-" for measuring a Hall voltage $U_H$ which is generated due to Lorentz forces within the semiconductor substrate Su. The semiconductor substrate Su may comprise semiconductor materials such as indium arsenide, gallium arsenide and indium antimonide.

Another pair of electrodes at the small lateral sides b is provided in order to apply an electrical current j in the lengthwise direction of the Hall sensor substrate Su. Due to the Lorentz forces, an electrical field E is generated within the semiconductor material resulting in a Hall voltage according to the following equation:

$$U_H = b \cdot E \qquad\qquad (4)$$

This Hall voltage $U_H$ may be used as a measure for the magnetic induction B and thus for the electric current 203 to be measured (Fig. 1).

It is noted here that, albeit magnetic field sensor units based on the Hall effect are described as sensors for the current measurement device according to a typical embodiment, other magnetic field sensor units may be employed such as magnetic field coils, Faraday rotation sensors based on optical waveguide fibers, etc.

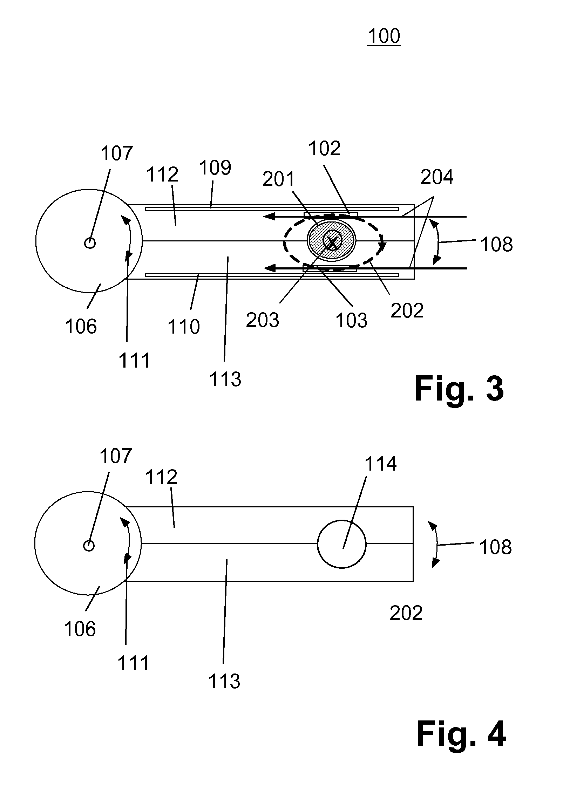

Fig. 3 is a sectional side view of a current measurement device 100 according to a typical embodiment.

As shown in Fig. 3, the electrical conductor 201, here shown in its cross-section, carries an electrical current such that a magnetic field 202 is generated. The magnetic field generation mechanism is similar to that depicted in Fig. 1. The magnetic field lines are shown by a dashed line 202. This magnetic field is detected by means of two magnetic field sensor units 102 and 103, i.e. a first magnetic field sensor unit 102 and a second magnetic field sensor unit 103.

The first and second magnetic field sensor units 102, 103 may be provided by Hall sensors, the present invention, however, is not restricted to the use of Hall sensors as magnetic field sensor units. If the electric current 203 to be measured flows in the indicated direction (into the plane of the drawing), a magnetic field is generated the direction of which is indicated by the arrow at the dashed line 202.

As shown in Fig. 3, the magnetic field 202 thus penetrates the first and second magnetic field sensor unit in mutually opposite directions, i.e. from left to right in Fig. 3 with respect to the first magnetic field sensor unit 102, and from right to left in Fig. 3 with respect to the second magnetic field sensor unit 103.

Using a Hall sensor detection unit shown in Fig. 2, the Hall voltages $U_H$ thus are mutually opposite to each other with respect to the first and second magnetic field sensor units 102, 103. By adding the inverse output signal of e.g. the second magnetic field sensor unit 103 to the output signal of the first magnetic field sensor unit 102, the Hall voltage 2 x $U_H$ is obtained. Thus, it is an advantage that the sensitivity of the current measurement device is increased by approximately a factor of two.

In addition to that, and in accordance with the core idea of the present invention, the current measurement device is not sensitive to magnetic stray fields indicated, e.g. by the arrows 204. At the location of the electric conductor 201, interfering magnetic fields penetrate both magnetic field sensor units 102, 103 in the same direction, e.g. in the direction indicated in Fig. 3.

Since the Hall voltage is generated by the Hall effect in the magnetic field sensor unit shown in Fig. 2, magnetic stray fields (interfering magnetic fields) generate identical Hall voltages $U_H$, both with respect to the magnitude and with respect to the direction. Thus, by adding the output signal of the first magnetic field sensor unit to the inverse output signal of the second magnetic field sensor unit, e.g., the effect of magnetic stray fields 204 is cancelled. Thus, the current measurement device 100 can be designed as a sensitive current sensor without being influenced by interfering magnetic fields.

In the following, the mechanical design of the current measurement device 100 will be described. As illustrated in Fig. 3, the first magnetic field sensor unit 102 and the second magnetic field sensor unit 103 are each fastened at a one-piece support unit 106.

The term "one-piece" support unit refers to a unit which is provided as one piece. This means that the one-piece support unit 106 is formed such as to provide a permanent connection between both magnetic field sensor units 102, 103 held by the support unit, not only when fastened, but also when not fastened and during normal fastening and unfastening by a user, without any necessity of being disassembled into more than one piece. The term "one-piece" does not exclude some restricted relative movement between portions of the one-piece support unit. Hence, two pieces such as two legs (e.g. a first conductor receiving section and a second conductor receiving section) connected by a hinge (as in Fig. 3) can be considered as a one-piece unit, because there is only restricted relative movement (only one rotational degree of freedom), whereas two portions only connected by e.g. a flexible cable cannot be considered as a one-piece unit, because free unrestricted relative movement of the pieces is possible (all three translational and three rotational degrees of freedom). The term "one-piece unit" does not imply that the unit is integrally formed, and the one-piece support unit may be disassembled outside of normal operation, e.g. for special maintenance or repair. In particular embodiments the one-piece support unit is also integrally formed. It is preferred that essentially at most one rotational degree of freedom is possible between individual components of the one-piece unit. Said at most one rotational degree of freedom is preferably provided by a hinge which rotatably connects two legs of the one-piece support unit such that both legs are tiltable with respect to each other about a central axis of the hinge.

The one-piece support unit 106 includes two conductor receiving sections 112 (first conductor receiving section) and 113 (second conductor receiving section) which are connected by the hinge 107. The two conductor receiving sections 112 and 113 and the hinge 107 form an integral unit, i.e. the support unit 106, wherein its both legs, i.e. the two conductor receiving sections 112 and 113 are tiltable about the central axis of the hinge 107. Thus the support unit 106 is provided as a one-piece unit which can be arranged adjacent to the electrical conductor 201.

The mechanical arrangement of the current measurement device 100 may be opened in a flapping direction 111 such that a flap angle 108 between the first conductor receiving section 112 and the second conductor receiving section 113 is provided. When the one-piece support unit is opened, the electrical conductor 201 may be inserted into a recess 114 without interrupting the current flow. The recess without the embedded electrical conductor 201 is shown in Fig. 4. Furthermore, as shown in Fig. 3, first and second substrates 109, 110 may be provided for the installation of the first magnetic field sensor unit 102 and the second magnetic field sensor unit 103, respectively.

Thus a fastening section is provided at the one-piece support unit 106 including the first conductor receiving section 112, the second conductor receiving section 113 and the recess 114. Thus the fastening section is designed for fastening the electrical conductor 201 such that the two magnetic field sensor units 102, 103 are held adjacent to the electrical conductor 201 when the electrical conductor 201 is fastened to the fastening section. The magnetic field sensor units 102, 103 are arranged on the one-piece support unit such that when the electrical conductor is fastened to the fastening section, a magnetic field generated by the electrical current 203 to be measured penetrates the two magnetic field sensor units 102, 103 in mutually opposite directions.

The one-piece support unit thus includes the hinge 107 and the two conductor receiving sections 112 and 113 on both sides of the hinge 107. The conductor receiving sections 112, 113 hold the two magnetic field sensors 102, 103 such that the one-piece support unit 106 can be form-fit to the shape of the electrical conductor 201 and that the two magnetic field sensors 102, 103 are on mutually opposite sides of the electrical conductor.

It is noted here that, albeit two magnetic field sensor units, i.e. a first magnetic field sensor unit 102 attached at the first conductor receiving section 112 of the one-piece support unit 106 and a second magnetic field sensor unit 103 attached at the second conductor receiving section 113 of the one-piece support unit 106 are provided, more than two magnetic field sensor units 102, 103 may be provided in order to increase the overall current sensitivity of the current measurement device 100.

The one-piece support unit 106 may formed as a clamp-on unit having a recess in the shape of the electrical conductor 201. Then the electrical conductor 201 is clamped when the conductor receiving sections 112 and 113 are closed, i.e. when the flap angle 108 shown in Fig. 3 is a minimum.

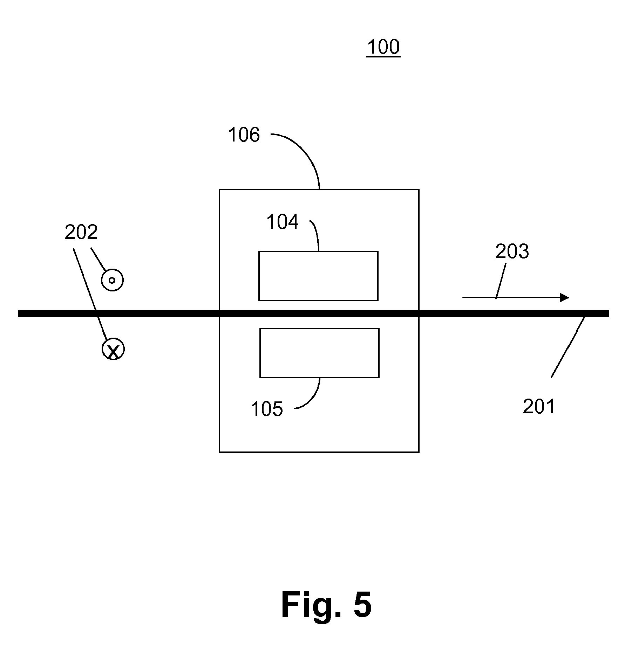

Fig. 5 is a current measurement device 100 according to another typical embodiment. As shown in Fig. 5, the current measurement device 100 includes a support unit 106 which is adapted to hold two different magnetic field sensor groups, i.e. a first magnetic field sensor group 104 and a second magnetic field sensor group 105. Both magnetic field sensor groups 104, 105 are arranged such that an electrical conductor 201 may pass in between a clearance between the first magnetic field sensor group 104 and the second magnetic field sensor group 105. A current flow 203 within the electrical conductor 201 in the direction shown by an arrow 203 in Fig. 5 results in a rotationally symmetric magnetic field 202 which is directed in accordance with the symbols "○" and "x" indicated in Fig. 5, left side.

As in the configuration shown in Fig. 3, the current measurement device 100 according to Fig. 5 comprises a one-piece support unit 106 for arranging first and second magnetic field sensor groups such that magnetic field 202 generated by the electrical current 203 to be measured penetrates the two magnetic field sensor groups 104, 105 in mutually opposite directions.

Thus interference magnetic fields or stray fields can have no influence, because magnetic stray fields, e.g. generated from external devices, will always penetrate the two magnetic field sensor groups in the same direction. Thus, a very high current measurement sensitivity can be obtained by the current measurement device. The first and second magnetic field sensor group 104, 105 may include Hall sensor units which have been described with respect to Fig. 2. It is noted that all other magnetic field sensors, however, may be applied as individual magnetic field sensor units.

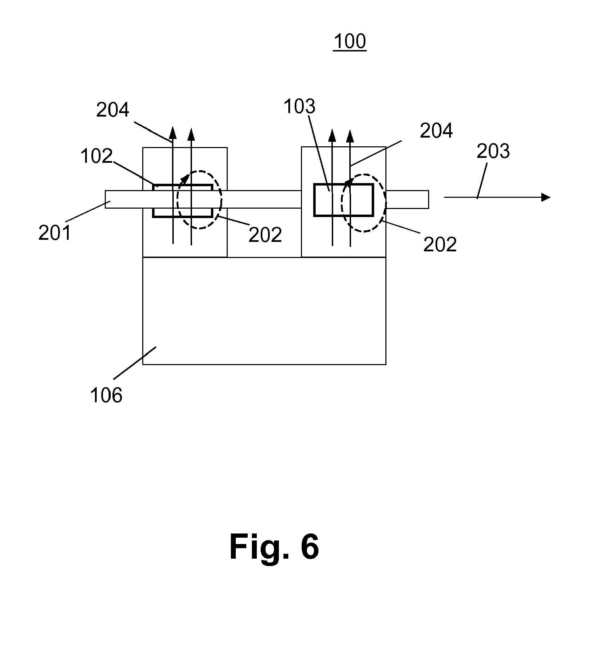

Fig. 6 is a side view of a current measurement device 100 for detecting a current flowing in an electrical conductor 201, wherein a support unit 106 for holding two magnetic field sensor units has a comb-like structure. The one-piece support unit 106, e.g. includes a base plate and supporting elements for holding the first and second magnetic field sensor units 102, 103. Dashed lines indicated by reference numerals 202 indicate a magnetic field to be measured.

The magnetic field is generated by a current flow 203 through the electrical conductor 201 which is guided through the comlike structure in a meander form. Arrows 204 indicate eventual magnetic stray fields which have the same directions at the location of the first and second magnetic field sensor units 102, 103. As indicated in Fig. 6, the first magnetic field sensor unit 102 is behind the electrical conductor in the side view shown in Fig. 6, wherein the second magnetic field sensor unit 103 is in front of the electrical conductor 201, as shown in the side view of Fig. 6.

The magnetic field generated by the current 203 to be measured penetrates the magnetic field sensor units 102, 103 in mutually opposite directions. Thus a magnetic stray field has not influence on the measurement result. The one-piece support unit 106 furthermore may be designed as a U-shape which is adapted for holding the two magnetic field sensor units 102, 103 at the respective ends of the U-shape.

It is noted here that, albeit the electrical conductor 201 has been described as an electrical wire, the electrical conductor furthermore can be designed as a flat cable conductor or a busbar.

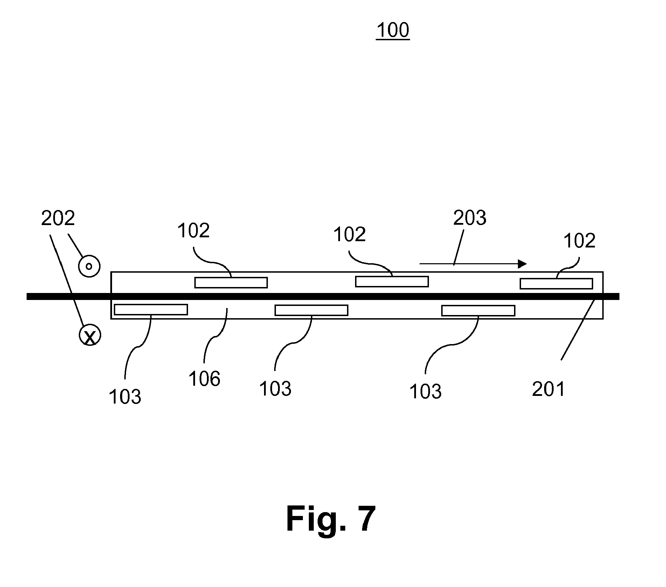

Fig. 7 is schematic top view of the current measurement device 100 shown in Fig. 6, according to yet another typical embodiment. Fig. 7 depicts a comb-like structure of the one-piece support unit 106 in more detail. The electrical current 203 flowing through the electrical conductor 201 generates the magnetic field 202 as described herein above.

As illustrated in Fig. 7, a plurality of first magnetic field sensor units 102 and a plurality of second magnetic field sensor units 103 are provided. In order to efficiently eliminate stray fields (not indicated in Fig. 7), the sum of the numbers of first magnetic field sensor units and the sum of the numbers of second magnetic field sensor units may be equal.

Thus an equal number of first magnetic field sensor units 102 and second magnetic field sensor units 103 are provided, such that the magnetic field 202 generated by the current 203 to be measured penetrates the first and second magnetic field sensor units 102, 103 in alternating directions. The one-piece support unit 106 is adapted for holding the plurality of magnetic field sensors in a comb-like structure adjacent to the electrical conductor.

In a further embodiment not shown in the figures, the first magnetic field sensor units and the second magnetic field sensor units can - different than shown in Fig. 7 - be arranged on a common line. Thus the first magnetic field sensor units and the second magnetic field sensor units are alternately arranged in the comb-like structure. The electrical conductor is guided though this structure in a meander form.

In a still further embodiment the current measurement device further comprising a current adjustment unit adapted for providing an adjustment of an electrical output current on the basis of the measured electrical current flowing through the electrical conductor.

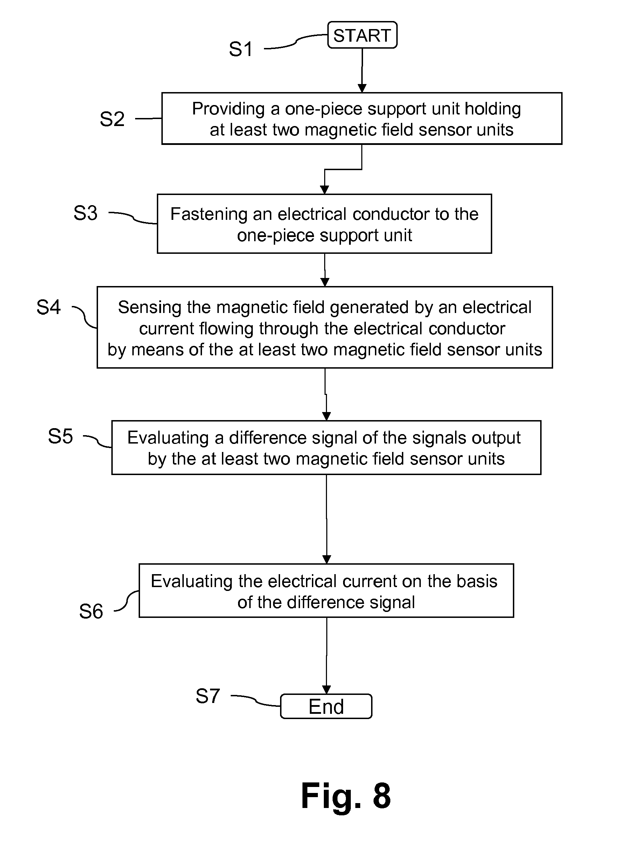

Fig. 8 is a schematic flowchart of a method for measuring an electrical current flowing through an electrical conductor, according to yet another typical embodiment.

At a step S1, the procedure is started. At a step S2, a one-piece support unit adapted for holding two magnetic field sensor units is provided. Then the procedure advances to a step S3, where an electrical conductor is fastened to the one-piece support unit. The electrical conductor is fastened to the one-piece unit such that the magnetic field generated by the current to be measured penetrates the two magnetic field sensor units in mutually opposite directions.

Then, at a step S4, the magnetic field generated by the electrical current flowing through the electrical conductor is probed by means of the two magnetic field sensor units. The signals of the two magnetic field sensor units may be provided individually for each magnetic field sensor unit. If an interfering magnetic stray field is present, the magnetic stray field is added to the magnetic field generated by the current to be measured at one of the two magnetic field sensor units, wherein the magnetic stray field is subtracted from the magnetic field generated by the current to be measured at the respective other magnetic field sensor unit due to the geometrical arrangement shown, e.g. with respect to Fig. 6 and 7.

At the step S5, a difference signal of the signals output by the two magnetic field sensor units is evaluated. This difference signal is only a function of the magnetic field generated by the current to be measured and no function of the magnetic stray field. Thus, a very sensitive current measurement device may be provided. At a step S7, the procedure is ended.

The invention has been described on the basis of embodiments which are shown in the appended drawings and from which further advantages and modifications emerge. However, the disclosure is not restricted to the embodiments described in concrete terms, but rather can be modified and varied in a suitable manner. It lies within the scope to combine individual features and combinations of features of one embodiment with features and combinations of features of another embodiment in a suitable manner in order to arrive at further embodiments.

It will be apparent to those skilled in the art, based upon the teachings herein, that changes and modifications may be made without departing from the disclosure and its broader aspects. That is, all examples set forth herein above are intended to be exemplary and non-limiting.

**REFERENCE NUMERALS**

| No. | Part/step |
| --- | --- |
| 100 | current measurement device |
| 101 | magnetic field sensor unit |
| 102 | first magnetic field sensor unit |
| 103 | second magnetic field sensor unit |

(continued)

| No. | Part/step |
|-----|-----------|
| 104 | first magnetic field sensor group |
| 105 | second magnetic field sensor group |
| 106 | support unit |
| 107 | hinge |
| 108 | flap angle |
| 109 | first substrate |
| 110 | second substrate |
| 111 | flapping direction |
| 112 | first conductor receiving section |
| 113 | second conductor receiving section |
| 114 | recess |
| 201 | electrical conductor |
| 202 | magnetic field to be measured |
| 203 | current |
| 204 | magnetic stray field |
| 205 | Hall sensor unit |

## Claims

1. Current measurement device adapted for measuring an electrical current (203) flowing through an electrical conductor (201), the current measurement device (100) comprising:

   two magnetic field sensors (102, 103) adapted for sensing a magnetic field (202) generated by the electrical current (203) to be measured; and
   a one-piece support unit (106) having a fastening section for fastening the electrical conductor (201), the one-piece support unit (106) being adapted to hold the two magnetic field sensors (102, 103) adjacent to the electrical conductor (201) when the electrical conductor (201) is fastened to the fastening section,

   wherein the magnetic field sensors (102, 103) are arranged on the one-piece support unit (106) such that when the electrical conductor (201) is fastened to the fastening section, a magnetic field (202) generated by the electrical current (203) to be measured penetrates the two magnetic field sensors (102, 103) in mutually opposite directions.

2. The current measurement device in accordance with claim 1,
   wherein the one-piece support unit (106) comprises a hinge (107) and two conductor receiving sections (112, 113) on both sides of the hinge (107), the conductor receiving sections (112, 113) holding the two magnetic field sensors (102, 103) such that, when the electrical conductor (203) is fastened to the fastening section and the hinge (107) is closed, the two magnetic field sensors (102, 103) are on mutually opposite sides of the electrical conductor (201).

3. The current measurement device in accordance with claim 2,
   wherein the fastening section is formed as a clamp-on unit having a recess (114) in the shape of the electrical conductor such that the electrical conductor (201) is clamped when the hinge (107) is closed.

4. The current measurement device in accordance with any one of the preceding claims, wherein the one-piece support unit (106) is formed in a U-shape adapted for holding the two magnetic field sensors (102, 103) at the respective ends of the U-shape when the electrical conductor (201) is fastened to the fastening section.

5. The current measurement device in accordance with any one of the preceding claims, wherein the fastening section comprises a comb-like structure which is adapted for fastening the electrical conductor (201) such that the electrical conductor (201) is guided through the comb-like structure in a meander form.

6. The current measurement device in accordance with any one of the preceding claims, wherein the magnetic field sensor units (102, 103) are Hall sensors (205).

7. The current measurement device in accordance with claim 5 or 6, wherein the one-piece support unit (106) is adapted for holding a plurality of magnetic field sensors (102, 103) in the comb-like structure adjacent to the electrical conductor (201), wherein the plurality of magnetic field sensors (102, 103) are arranged on the one-piece support unit (106) such that when the electrical conductor (201) is fastened to the fastening section, a magnetic field (202) generated by the electrical current (203) to be measured penetrates two adjacent magnetic field sensors (102, 103) of the plurality of magnetic field sensors in mutually opposite directions.

8. The current measurement device in accordance with any one of the preceding claims, comprising an even number of magnetic field sensors (102, 103).

9. The current measurement device in accordance with any one of the preceding claims, wherein the two conductor receiving sections (112, 113) on both sides of the hinge (107) are adapted to receive an electrical conductor (201) which is formed as at least one of a wire having a circular cross section, a flat cable conductor, and a bus bar.

10. The current measurement device in accordance with any one of the claims 1 to 9, further comprising a current adjustment unit adapted for providing an adjustment of an electrical output current on the basis of the measured electrical current flowing through the electrical conductor.

11. A method for measuring an electrical current (203) flowing through an electrical conductor (201), the method comprising:

 providing two magnetic field sensors (102, 103);
 fastening the electrical conductor (201) to a one-piece support unit (106) by means of a fastening section of the one-piece support unit (106), thereby holding the two magnetic field sensors (102, 103) adjacent to the electrical conductor (201) such that a magnetic field (202) generated by the electrical current (203) to be measured penetrates the two magnetic field sensors (102, 103) in mutually opposite directions; and
 sensing the magnetic field generated by the electrical current (203) to be measured.

12. The method in accordance with claim 11, wherein a difference signal of signals output by the two magnetic field sensor units (102, 103) is evaluated.

13. The method in accordance with claim 11 or 12, wherein the two magnetic field sensors (102, 103) are held at respective ends of a U-shape defined by the support unit.

14. The method in accordance with any one of the preceding method claims, wherein the magnetic field (202) generated by the electrical current (203) to be measured penetrates a plurality of magnetic field sensors (102, 103) arranged in a comb-like structure of the support unit, wherein the magnetic field (202) penetrates two adjacent magnetic field sensors (102, 103) of the plurality of magnetic field sensors in mutually opposite directions.

**Fig. 1**

101, 205

$U_H$

$\vec{B}$

$\vec{E}$

$\vec{j}$

s

Su

b

# Fig. 2

100

**Fig. 3**

**Fig. 4**

100

106

104

202

203

105

201

Fig. 5

**Fig. 6**

**Fig. 7**

S1 — START

S2 — Providing a one-piece support unit holding
at least two magnetic field sensor units

S3 — Fastening an electrical conductor to the
one-piece support unit

S4 — Sensing the magnetic field generated by an electrical
current flowing through the electrical conductor
by means of the at least two magnetic field sensor units

S5 — Evaluating a difference signal of the signals output
by the at least two magnetic field sensor units

S6 — Evaluating the electrical current on the basis
of the difference signal

S7 — End

# Fig. 8

Europäisches
Patentamt

European
Patent Office

Office européen
des brevets

**EUROPEAN SEARCH REPORT**

Application Number

EP 08 17 2671

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/156587 A1 (YAKYMYSHYN CHRISTOPHER P [US] ET AL YAKYMYSHYN CHRISTOPHER PAUL [US] E) 21 July 2005 (2005-07-21) * abstract; figures 1A,1B,3 * * paragraph [0026] - paragraph [0067] * | 1-14 | INV. G01R15/20 |
| X | JP 2007 107972 A (DENSO CORP) 26 April 2007 (2007-04-26) * abstract; figures 1,4,11,12 * | 1,4-8, 10-14 | |
| X | US 5 473 244 A (LIBOVE JOEL M [US] ET AL) 5 December 1995 (1995-12-05) * column 3, line 55 - column 8, line 9; figures 3,4,5A * | 1-14 | |
| Y | US 2005/073292 A1 (HASTINGS JEROME K [US] ET AL) 7 April 2005 (2005-04-07) * abstract; figures 1-3 * * paragraph [0030] - paragraph [0047] * | 1-14 | |
| X | DE 199 14 772 A1 (AEG NIEDERSPANNUNGSTECH GMBH [DE]) 12 October 2000 (2000-10-12) * abstract; figures 1,3-5 * | 1,6,8-12 | TECHNICAL FIELDS SEARCHED (IPC) G01R |
| Y | JP 2007 303952 A (YAZAKI CORP) 22 November 2007 (2007-11-22) * abstract; figures 1-3 * | 1-14 | |
| A | JP 59 071176 U (-) 15 May 1984 (1984-05-15) * figures 1,3 * | 1-14 | |

The present search report has been drawn up for all claims

| Place of search | Date of completion of the search | Examiner |
|---|---|---|
| Berlin | 29 May 2009 | Ernst, Monika |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 17 2671

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2009

| Patent document cited in search report | | Publication date | Patent family member(s) | | Publication date |
|---|---|---|---|---|---|
| US 2005156587 | A1 | 21-07-2005 | US 2007063691 A1<br>US 2007057662 A1<br>US 2007205750 A1<br>US 2007205749 A1 | | 22-03-2007<br>15-03-2007<br>06-09-2007<br>06-09-2007 |
| JP 2007107972 | A | 26-04-2007 | NONE | | |
| US 5473244 | A | 05-12-1995 | NONE | | |
| US 2005073292 | A1 | 07-04-2005 | NONE | | |
| DE 19914772 | A1 | 12-10-2000 | AU 2438700 A<br>CA 2368901 A1<br>CN 1353818 A<br>WO 0060366 A1<br>EP 1166131 A1<br>JP 2002541460 T | | 23-10-2000<br>12-10-2000<br>12-06-2002<br>12-10-2000<br>02-01-2002<br>03-12-2002 |
| JP 2007303952 | A | 22-11-2007 | NONE | | |
| JP 59071176 | U | 15-05-1984 | JP 1022140 Y2 | | 29-06-1989 |

EPO FORM P0459

For more details about this annex : see Official Journal of the European Patent Office, No. 12/82